(19) Europäisches Patentamt
European Patent Office
Office européen des brevets

(11) Veröffentlichungsnummer: **0 167 963**
**B1**

(12) **EUROPÄISCHE PATENTSCHRIFT**

(45) Veröffentlichungstag der Patentschrift: **04.04.90**

(51) Int. Cl.$^5$: **G 03 F 7/021**

(21) Anmeldenummer: **85108159.6**

(22) Anmeldetag: **01.07.85**

# (54) Lichtempfindliches Gemisch und damit hergestelltes lichtempfindliches Aufzeichnungsmaterial.

(30) Priorität: **10.07.84 DE 3425328**

(43) Veröffentlichungstag der Anmeldung:
**15.01.86 Patentblatt 86/03**

(45) Bekanntmachung des Hinweises auf die Patenterteilung:
**04.04.90 Patentblatt 90/14**

(84) Benannte Vertragsstaaten:
**AT BE CH DE FR GB IT LI NL SE**

(56) Entgegenhaltungen:
**EP-A-0 061 150**
**EP-A-0 071 881**
**EP-A-0 104 863**
**DE-A-3 605 717**
**FR-A-2 450 473**
**US-A-4 316 949**

**PATENT ABSTRACTS OF JAPAN, Band 7, Nr. 48 (P-178)1193r, 24. Februar 1983; & JP-A-57 196 230 (MITSUBISHI KASEI KOGYO K.K.) 02-12-1982**

(73) Patentinhaber: **HOECHST AKTIENGESELLSCHAFT**
**Postfach 80 03 20**
**D-6230 Frankfurt am Main 80 (DE)**

(72) Erfinder: **Frommeld, Hans-Dieter, Dr. Dipl.-Chem.**
**Simrockstrasse 7A**
**D-6200 Wiesbaden (DE)**
Erfinder: **Lutz, Walter, Dr. Dipl.-Chem.**
**Herderstrasse 21**
**D-6230 Hochheim/M (DE)**
Erfinder: **Steppan, Hartmut, Dr. Dipl.-Chem.**
**Panoramastrasse 17**
**D-6200 Wiesbaden-Dotzheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 167 963 B1

**Beschreibung**

Die Erfindung betrifft ein negativ arbeitendes lichtempfindliches Gemisch, das ein Diazoniumsalz-Kondensationsprodukt, eine polymerisierbare Verbindung, einen Photoinitiator und ein Bindemittel enthält, sowie ein damit hergestelltes Aufzeichnungsmaterial, das vorzugsweise für die Herstellung von Flachdrukplatten geeignet ist.

Kombinationen von photopolymerisierbaren Gemischen mit negativ arbeitenden Diazoverbindungen, besonders Diazoniumsalz-Polykondensationsprodukten, sind aus den DE—A—23 61 931, 29 03 270 und 320 07 212 (= GB—A—2 044 788) bekannt. Dabei wirkt entweder die Diazoverbindung selbst als Photoinitiator für die Polymerisation des Monomeren oder es wird ein zusätzlicher Photoinitiator zugesetzt. Als Vorteil wird vor allem die bessere Auflösung der Kopie gegenüber reinen photopolymerisierbaren Schichten und die erhöhte Druckauflage gegenüber Schichten angegeben, die allein Diazoverbindungen als lichtempfindliche Substanzen enthalten. Auch ist es in bestimmten Fällen möglich, die Entwicklung mit wäßrigen Lösungen oder sogar mit reinem Wasser duchzufürhen.

Ein ähnliches Gemisch, das ein Bindemittel mit vernetzbaren seitenständigen Allylgruppen entählt, wird in der EP—A—104 863 beschrieben.

In allen diesen Druckschriften werden als Diazoniumsalz-Polykondensationsprodukte solche Verbindungen offenbart, die durch Kondensation von Diphenylamin-4-diazoniumsalzen mit Formaldehyd und gegebenenfalls spätere Modifizierung des Diazoniumsalzanions hergestellt worden sind.

Bei den bekannten Kombinationen, die teils noch wasserlösliche Polymere enthalten, zeigt sich häufig eine Empfindlichkeit gegen ungünstige Klimaeinflüsse wie erhöhote Temperatur oder Luftfeuchtigkeit, die zumeist mit einer geringeren Lagerfähigkeit verbunden ist. Auch ist die Haftung der Schicht, insbesondere im belichtenen Zustand, an dem Schichtträger in vielen Fällen nicht optimal.

Aus der US—A—3 867 147 sind Diazoniumsalz-Polykondensationsprodukte bekannt, die außer Diazoniumsalzeinheiten noch weitere, von Diazoniumgruppen freie Einheiten enthalten, die untereinander und mit den Diazoniumsalzeinheiten durch zweibindige, von aktiven Carbonylverbindungen abgeleitete Bindeglieder, insbesondere Methylengruppen, verknüpft sind. Diese Polykondensationsprodukte können mit Bindemitteln kombiniert werden und ergegen Drukplatten mit höherer Lichtempfindlichkeit und geringerer Feuchtigkeitsempfindlichkeit als die zuvor genannten Formaldehyd-Kondensationsprodukte.

Aufgabe de Erfindung war es, eine negative arbeitendes lichtempfindliches Gemisch bereitzustellen, das sich durch eine Kombination von güter Auflösung und hoher Druckauflage auszeichnet und zusätzlich eine höhere Lichtempfindlichkeit, höhere Lagerfähigkeit im unbelichteten Zustand un eine bessere Schichthaftung aufweist.

Erfindungsgemäß wird ein lichtempfindliches Gemisch vorgeschlagen, das als wesentliche Bestandteile

a) eine Diazoniumsalz-Polykodesationsprodukt,

b) eine radikalisch polymerisierbare Verbindung mit mindestens zwei endständigen ethylensich ungesättigten Gruppen und einem Siedepunkt bei Normaldruck oberhalb 100°C,

c) einen unter Einwirkung von aktinischer Strahlung Radikale bildenen Polymerisationsinitiator und

d) ein in Wasser unlösliches, in organischen Lösungsmitteln lösliches polymeres Bindemittel

enthält.

Das erfindungsgemäße Gemisch ist dadurch gekennzeichnet, daß das Diazoniumsalz-Polykondensationsprodukt wiederkehrende Einheiten $A—N_2X$ und B enthält, die durch zweibindige, von einer kondensationsfähigen Carbonylverbindung, abgeleitete Zwischenglieder verbunden sind, wobei die Einheiten $A—N_2X$ sich aus Verbindungen der allgemeinen Formel

$$(R^1—R^3—)_pR^2—N_2X$$

ableiten und wobei

X das Anion der Diazoniumverbindung,

p eine ganze Zahl von 1 bis 3,

$R^1$ eine carbocyclischen oder heterocyclischen aromatischen Rest mit mindestens einer kondensationsfähigen Position,

$R^2$ eine Arylengruppe der Benzol- oder Naphthalinreihe,

$R^3$ eine Einfachbindung oder eine der Gruppen:

$$—(CH_2)_q—NR^4—$$

$$—O—(CH_2)_r—NR^4—,$$

$$—S—(CH_2)_r—NR^4—,$$

$$—S—CH_2—CO—NR^4—,$$

—O—$R^5$—O—,

—O—,

—S— oder

—CO—$NR^4$—

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylgruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

Erfindungsgemäß wird ferner ein lichtempfindliches Aufzeichnungsmaterial mit einem Schichtträger und einer darauf aufgebrachten lichtempfindlichen Schicht vorgeschlagen, das insbesondere für die Herstellung von Flachdruckplatten geeignet ist und das dadurch gekennzeichnet ist, daß die lichtempfindliche Schicht aus einem Gemisch der vorstehend definierten Zusammensetzung besteht.

Die in dem erfindungsgemäßen Gemisch enthaltenen Diazoniumsalz-Polykondensationsprodukte sind in der US—A—3 867 147 eingehend beschrieben. Von den dort gennannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponenten B werden die gegebenenfalls substituierten Diphenylether, Diphenylsulfide, Diphenylmethane oder Diphenyle bevorzugt. Dabei werden für die Kondensation die Bis-methoxymethyl-, Bis-hydroxymethyl- oder Bis-acetoxymethylderivate der Grundkörper mit beseonderem Vorteil eingesetzt. Das Kondsationsprodukt kann im Mittel 0,1 bis 50, bevorzugt 0,2 bis 20 Einheiten B je Einheit A—$N_2X$ enthalten.

Der Mengenanteil des Diazoniumsalz-Polykondensationsprodukts in dem Gemisch liegt im allgemeinen zwischen 5 und 60, vorzugsweise zwischen 10 und 30 Gew.-%, bezogen auf den Gesamtgehalt an nichtflüchtigen Gestandteilen.

Weitere besonders vorteilhafte Polykondensationsprodukte werden erhalten, indem ein ggf. substituiertes Diphenylamindiazoniumsalz zuerst mit einer aromatischen Verbindung R'—O—$CH_2$—B und danach mit einer aromatischen Verbindung R'—O—$CH_2$—B—$Ch_2$—O—R' kondensiert wird, wobei R' ein Wasserstoffatom, ein Alkyl- oder aliphatischer Acylrest ist. Diese Kondensationsprodukte sind in der älteren, nicht vorveröffentlichten DE—A 33 11 435 beschrieben.

Als radikalisch polymerisierbare Verbiundungen werden bevorzugt Acryl- oder Methacrylsäureester von mehrewertiegen, insbesondere primären Alkoholen eingesetzt. Die Alkohole können 2 bis 6, bevorzugt 2 bis 4 OH-Gruppen enthalten. Es können auch kleinere Mengen (Meth)acrylester einwertiger Alkohole im Gemisch enthalten sein. Beispiele für geeignete Ester sind Trimethylolpropantriacylat, Pentaerylthrittri- und tetraacrylat, Dipentaerythrithexamethacrylat, Propyllenglykoldimethacylat, Glycerindimethacrylat, Triethylenglykoldimethacrylat, Polyethylenglykoldiacrylat und Bisacrylate von oxyethylierten Bisphenol-A-Derivaten. Es sind auch die niedermolekularen, Urethangruppen enthaltenden Acrylate und Methacrylate geeignet, die durch Umsetzen von Hydroxyalkylacrylat oder -methacrylat mit zwei- oder mehrwertigen Isocyanaten erhalten werden. Die Isocyanate können wiederum durch Umsetzen von Diioscyanaten mit Diolen oder Triolen zu oligemeren Verbindung erhlaten worden sein. Die Menge an polymerisierbaren Verbindungen liegt im allgemeinen zwischen 10 und 65, bevorzugt bei 20 bsi 56 Gew.-%.

Als Photoinitiatoren können eine Vielzahl von Verbindungen, gegebenenfalls auch Gemische von zwei oder mehreren verschiedenen, oftmals synergistisch wirkenden Verbindungen Verwendung finden. Beispiele sind Benzoin und seine Derivate, Mehrkernchinone, Acridinderivate, z.B. 9-Phenyl-acridin, 9-p-Methoxyphenyl-acridin, Benz(a)-acridin; Phenazinderivate, z.B. 9,10-Dimethyl-benz(a)-phenazin, 10-Methoxy-benz(a)phenazin; Chinoxalinderivate, z.B. 6,4',4''-Trimethoxy-2,3-diphenyl-chinoxalin, 4,4''-Dimethoxy-2,3-diphenyl-5-azachinoxalin; aromatisch substituierte Bis-trichlormethyl-s-triazine oder trichlormethylsubstituierte Carbonylmethylenheterocyclen, z.B. 2-(p-Trichlormethyl-benzoylmethylen)-3-ethylbenzthiazolin. Die Trichlormethylverbindungen werden besonders bevorzugt. Die Menge des Photoinitiators liegt im allgemeinen zwischen 0,05 und 10, bevorzugt zwischen 0,1 und 5 Gew.-%.

Als Bindemittel sind vorwiegend wasserunlösliche Polymere, wie Polyacrylate, Polymethacrylate, Polyvinylester und Polyvinylacetate, Epoxyharze, Polyurethane, Polysulfonylethane und Polyvinylphenole geeignet. Auch Mischpolymerisate von Crotonsäure, Maleinsäureanhydrid, Acryl- oder Methacrylsäure mit Alkyl(meth)acrylaten, Acrylnitril, Styrol, Vinylacetat oder ähnlichen Monomeren sind geeignet.

Die erfindungsgemäßen Gemische können ferner Säuren, Inhibitoren für die thermische Polymerisation, Farbstoffe, Pigmente, Verlaufmittel, Weichmacher, Netzmittel und andere übliche Zusätze enthalten.

Die Gemische werden bevorzugt zur Herstellung lichtempfindlicher Druckplatten, insbesondere Flachdruckplatten, eingesetzt. In diesem Fall werden als Schichtträger vorwiegend Metalle, wie Zink, Stahl, verchromter Stahl Messing/Chrom, Kupfer/Chrom oder Aluminium verwendet. Für Flachdruckplatten wird Aluminium bevorzugt, insbesondere mechanisch, chemisch oder elektrolytisch aufgerauhtes Aluminium, das bevorzugt noch mit einer anodisch erzeugten Oxidschicht versehen ist.

Die Gemische können auch in der Photoresisttechnik eingesetzt werden, z.B. zur Herstellung von Hoch-, Tief- oder Mehrmetalldruckplatten oder von gedruckten Schaltungen. Bei dieser Anwendung ist in vielen Fällen die erhöhte Auflösung gegenüber den sonst verwndeten photopolymerisierbaren Gemsichen von besonderem Vorteil.

Bei allen Anwendungen kommen als Vorteile der erfindungsgemäßen Gemsiche gegenüber den bekannten Gemischen auf Basis Photopolymer/Diazoniumsalz-Kondensat eine erhöhte Lichtempfindlichkeit, erhöhte lagerfähigkeit und verbesserte Haftung der lichtempfindlichen Schicht, insbesondere im belichteten Zustand, zer Geltung.

Als Lösemittel zur Bereitung der Beschichtungslösungen können je nach den Schichtbestandteilen z.B. Alkohole, wie Methanol und Ethanol; Glykolether wie Ethylenglykolmonoethylether; Dimethylformamid und Diethylformamid, Ether wie Dioxan, Tetrahydrofuran; Ester wie Essigsäureethylester, Butylacetat, Ethylenglykolmethyletheracetat; Ketone wie Methylethylketon, Cyclohexanon usw., verwendet werden.

Die lichtempfindliche Schicht kann in üblicher Weise durch Aufbringen der Lösung ihrer Bestandteile auf den Schichtträger erzeugt werden. Sie kann auch zunächst auf einen temporären Schichtträger aufgebracht werden, von dem sie mechanisch abtrennbar ist, und durch Laminieren auf den endgültigen Schichtträger, z.B. eine Nickelfolie oder die Kupferschicht eines Leiterplatten-Basismaterials übertragen werden.

Bei der Verarbeitung wird das Aufzeichnungsmaterial bildmäßig durch eine Vorlage belichtet. Zur Bildbelichtung kann jede in der Reproduktionstechnick gebräuchliche Lichtquelle dienen, die im langwelligen UV-Bereich emittiert, z.B. Kohlenbogenlampen, Quecksilberhockdrucklampen, Xenonimpulslampen und andere. Auch Elketronen- oder Laserstrahlung ist zur Bildaufzeichnung geeignet.

Nach der Belichtung wird mit einem geeigneten Entwickler entwickelt. Als Entwickler können z. B. wäßrige Netzmittellösungen, ggf. unter Zusatz von Alkali, deren Gemische mit organischen Lösemitteln, wäßrige Salzlösungen, wäßrige Lösungen von Säuren z. B. von Phosphorsäuren, denen wiederum Salze oder organische Lösemittel zugesetzt werden können, oder wäßrig-alkalische Entwickler verwendet werden, z.B. wäßrige Lösungen von Natriumsalzen der Phosphorsäure oder der Kieselsäure. Auch diesen Entwicklern können organische Lösemittel zugesetzt werden. Es ist in manchen Fällen auch möglich, mit Wasser verdünnte organische Lösemittel zu verwenden. Die Entwickler können noch weitere Bestandteile, z. B. Netzmittel und Hydrophilerungsmittel, enthalten.

Die Entwicklung erfolgt in bekannter Weise, z. B. durch Tauchen und/oder Überwischen oder Besprühen mit der Entwicklerflüssigkeit. Dabei werden die nicht belichteten Schichtbereiche gelöst.

Die nachstehenden Beispiele beschreiben die Herstellung der erfindungsgemäßen lichtempfindlichen Gemische und der mit diesen hergestellten Aufzeichnungsmaterialien. In den Beispielen stehen Gewichtsteile (Gt.) und Volumenteile (Vt.) zueinander im Verhältnis von g zu ml. Prozentangaben sind, wenn nichts anderes angegeben ist, Gewichsprozente, Temperaturen sind in °C angegeben.

### Beispiel 1

Drei lichtempfindliche Lösungen wurden durch Auflösen der folgenden Bestandteile in der unten angegebenen Stammlösung hergestellt:

a) 7,0 Gt des Polykondensationsproduktes aus 1 mol Diphenylamin-4-diazoniumsulfat und 1 mol Formaldehyd, ausgefällt als 2-Hydroxy-4-methoxy-benzophenon-5-sulfonat (13,6 mmol, bezogen auf Benzoldiazoniumeinheiten),

b) 7,0 Gt des Polykondensationsproduktes aus 1 mol 3-Methoxy-diphenylamin-4-diazoniumsulfat und 1 mole 4,4'-Bis-methoxymethyl-diphenylether, ausgefällt als 2-Hydroxy-4-methoxybenzophenon-5-sulfonat (9,6 mmol)

c) 9,9 Gt des unter b angegebenen Polykondensationsprodukts (13,6 mmol)

Stammlösung:

100 Gt Dimethylformamid,
150 Gt Tetrahydrofuran,
100 Gt Methanol,
120 Gt einer 1%igen Lösung von 2-(4-Ethoxy-naphth-1-yl)-4,6-bis-trichlormethyl-s-triazin in 2-Methyoxy-ethanol,
40 Gt einer 25%igen Lösung von Dipentaerythrithexaacrylat in Methylethylketon,
15 Gt eines Copolymeren aus 95% Vinylacetat und 5% Crotonsäure,
50 Gt einer 1%igen Lösung von Phosphorsäure in 2-Methoxy-ethanol und
0,7 Gt Viktoriareinblau FGA (C.I. 42595).

Mit jeder dieser drei Lösungen wurde durch Drahtbürsten aufgerauhte Aluminiumfolie beschichtet und anschließend bei Temperaturen bis 100°C zwei Minuten getrocknet (Schichtgewicht ca. 1,2 g/m$^2$). Die Muster 1a, 1b und 1c wurden unter einer Rastervorlage in einem Vakuumkopierrahmen mit einer 5 kW Metallhalogenidlampe 60 Sekunden belichtet und anschließend mit einer Lösung aus

15 Gt Pelargonsäure,
10 Gt Natriumhydroxid,

92 Gt eines Blockpolymerisats aus 90% Propyleneoxid und 10% Ethylenoxid und
12 Gt Natriumtetrapolyphosphat in
550 Gt Wasser
innerhalb 30 Sekunden entwickelt.

Die Probe a zeigte danach ein aufgerissenes Bild, durch Reiben mit dem Finger konnten die Rasterfelder zerstört werden. Dagegen zeigten die erfindungsgemäßen Muster b und c gut haftende, scharfe Bilder.

Um den Einfluß der geringeren Lichtempfindlichkeit der Lösung a auszugleichen, wurde die Probe a auch 120 und 180 Sekunden belichtet und dann ebenso wie oben entwickelt. Aber auch so erhielt man im Gegensatz zu den erfindungsgemäßen Mustern b und c ungenügend haftende Rasterpunkte, d. h. eine unbrauchbare Druckform.

Die Lösungen a, b und c wurden auch auf elektrochemisch aufgerauhte und anodisierte Aluminiumfolie aufgeschleudert (Schichtgewicht 1,5 g/m$^2$). Die Proben wurden unter einem Halbtonstufenkeil mit dem Dichteumfang 0,05 bis 3,05, wobei die Dichteinkremente 0,15 betrugen, belichtet. Wurde die Probe a mit 120 Sekunden, die Probe b mit 60 Sekunden und die Probe c mit 52 Sekunden belichtet, so erhielt man bei gleicher Entwicklung wie oben Stufenkeile gleicher Länge. Das bedeutet, daß die erfindungsgemäßen Muster b und c erheblich lichtempfindlicher sind.

Wurden unbelichtete Proben a—c auf elektrochemisch aufgerauhter und anodisierter Aluminiumfolie, 0,5; 1; 2; 3 und 4 Stunden bei 100°C, also unter forcierten Bedingungen, gelagert, so war die Probe a nach 2 Stunden nicht mehr tonfrei entwickelbar. Die Proben b und c waren nach dieser Zeit und nach 3 Stunden noch brauchbar, erst nach 4 Stunden bei 100°C ließen sich die erfindungsgemäßen Proben b und c nicht mehr tonfrei entwickeln.

## Beispiel 2

Der Versuch von Beispiel 1 wurde wie folgt abgewandelt:

Anstelle des Photoinitiators 2-(4-Ethoxy-naphth-1-yl)-4,6-bis-trichlormethyl-s-triazin wurden 1,2 g 2-(4-Trichlormethyl-benzoylmethylen)-3-ethyl-benzothiazolin

Anstelle von Dipentaerythrithexaacrylat ein Reaktionsprodukt aus 2 mol 2,2,4-Trimethylhexamethylendiisocyanat, 1 mol Triethylenglykol und 2 mol Hydroxyethylmethacrylat in gleicher Gewichtsmenge

und als polymeres Bindemittel ein Copolymeres aus 90% Vinylacetat und 10% Crotonsäure verwendet.

Wieder wiesen die erfindungsgemäßen Druckplatten eine um 50 bis 100% höhere Lichtempfindlichkeit, eine bessere Lagerfähigkeit unter forcierten Bedingungen, insbesondere aber eine stark verbesserte Haftung der Schicht am Träger auf.

## Beispiel 3

Es wurden zwei lichtempfindliche Lösungen aus folgenden Bestandteilen hergestellt:
100 Gt Dimethylformamid,
150 Gt Tetrahydrofuran,
100 Gt Methanol,
170 Gt 2-Methoxy-ethanol,
30 Gt Methylethylketon,
10 Gt Pentaerythrittetraacrylat/-triacrylat (technisches Gemisch)
15 Gt Polyvinylacetat mit einem mittleren Molekulargewicht von 35.000,
1,2 Gt 2-(4-Styryl-phenyl)-4,6-bis-trichlormethyl-s-triazin,
0,5 Gt Phosphorsäure
0,7 Gt Viktoriareinblau FGA und

a) 7 Gt des Polykondensationsproduktes aus 1 mol 3-Methoxy-diphenylamin-4-diazoniumsulfat und 1 mol Formaldehyd, ausgefällt als Mesitylensulfonat oder

b) 7 Gt des Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat.

Mit diesen Lösungen wurde durch Drahtbürsten aufgerauhte Aluminiumfolie beschichtet und dann getrocknet (Schichtgewicht 1,6 g/m$^2$).

Wegen der geringeren Lichtempfindlichkeit wurde das Muster a 120 und das erfindungsgemäße Muster b 60 Sekunden unter einer Strickvorlage belichtet.

Die belichteten Druckplatten wurden in einen Entwickler, bestehend aus
5 Gt Natriumoctylsulfat,
1,5 Gt Natriummetasilikat × 9 $H_2O$,
1,5 Gt Trinatriumphosphat und
92 Gt entsalztes Wasser
getaucht und in einem Versuch nach 30 Sekunden, in einem zweiten Versuch nach 120 Sekunden mit einem Tampon leicht überwischt und mit Wasser abgespült.

Die Platten a und b waren nach 30 Sekunden Einwirkung des Entwicklers voll entwickelt. Die Einwirkung von 120 Sekunden führte bei der Platte a auch in den lichtgehärteten Teilen zur Schichtablösung, während die erfindungsgemäße Platte b noch ein gutes Bild zeigte.

Wurde die Platte a ebenfalls nur 60 Sekunden belichtet, so war die Haftung der lichtgehärteten Schichtbereiche am Schichtträger noch geringer.

Beispiel 4

Lichtempfindliche Lösungen wurden durch Lösen und Mischen folgender Bestandteile hergestellt:

14,5 mmol eines Diazoniumsalz-Polykondensats (bezogen auf Benzoldiazoniumsalzeinheiten),
100 g Dimethylformamid,
150 gTetrahydrofuran,
100 g Methanol,
120 g einer 1%igen Lösung von 2-(4-Methoxystryl)-4,6-bis-trichlormethyl-s-triazin,
40 g einer 25%igen Lösung des in Beispiel 3 angegebenen Monomeren in Methylethylketon,
15 g eines Polymeren aus Styrol und Maleinsäuremonoallylester (Molverhältnis 1:1; Molekulargewicht 65 000),
10 g der 0,5%iegen Lösung eines Mischpolymerisats aus Dimethyldichlorsilan und Ethylenoxid in Dimethylformamid,
50 g einer 1%igen Lösung von Phosphorsäure in 2-Methoxy-ethanol und
0,7 g Viktoriareinblau FGA.

14,5 mmol Diazoniumsalz-Polykondensat entsprechen

9,9 g des Polykondensationsproduktes aus 1 mol 3-Methoxy-diphenylamin-4-diazoniumsulfat und 1 mol 4,4'-Bis-methoxymethyl-diphenylether, ausgefällt als 2-Hydroxy-4-methoxybenzophenon-5-sulfonat (Beispiel 4a),
7,0 g des Polykondensationsproduktes aus 1 mol Diphenylamin-4-diazoniumsulfat und 1 mol Formaldehyd, ausgefallt als 2-Hydroxy-4-methoxy-benzophenon-5-sulfonat (Beispiel 4b),
6,9 g des Polykondensationsproduktes aus 1 mol 3-methoxy-diphenylamin-4-diazoniumsulfat und 1 mol 4,4'-Bis-methoxymethyl-diphenylether, ausgefällt als Tretrafluoroborat (Beispiel 4c) und
4,0 g des Polykondensationsproduktes aus 1 mol Diphenylamin-4-diazoniumsulfat und 1 mol Formaldehyd, ausgefällt als Tetrafluoroborat (Beispiel 4d)

Die Lösungen 4a bis 4d wurden auf elektrochemisch aufgerauhte und anodisierte Aluminiumfolie (Proben a, b, c, d) sowie auf mit Drahtbürsten aufgerauhtes Aluminium aufgebracht (Proben aa, bb, cc, dd). Zur Bestimmung der Lichtempfindlichkeit wurden die Proben a bis d unter einem Halbtonkeil derart belichtet, daß nach der Entwicklung (Entwickler von Beispiel 1; 1 Minute) die Stufenkeile die gleiche Länge zeigten.

Die folgende Tabelle gibt die erforderlichen Belichtungszeiten an, die erforderlich sind, um die Stufe 5 wiederzugeben; in der zweiten Zeile ist die Lagerfähigkeit beim 100°-Test angegeben.

| | a erfindungsgemäß | b | c erfindungsgemäß | d |
|---|---|---|---|---|
| Belichtungszeit | 70 s | 110 s | 50 s | 70 s |
| Haltbarkeit bei 100°C | 3 Std. | 1,5 Std | 2 Std. | 30 min |

Die Proben aa, bb, cc und dd wurden unter einer Rastervorlage entsprechend den oben ermittelten Belichtungszeiten belichtet und dann entwickelt. Auf die Muster werde ein Haftklebestreifen aufgebracht, der mit gleichem Druck angepreßt wurde und dann nach 1 Stunde wieder abgezogen wurde.

Je nach Haftungsgüte wurden Schichtbestandteile mit dem Klebestreifen abgerissen.

Probe aa: 0—10% sehr wenig
Probe bb: 50—70% stark zerrissenes Bild
Probe cc: 0% keine Ablösung
Probe dd: 30—40% deutliche Schädigung.

Durch die erfindungsgemäßen Diazoniumsalze wird die Haftung deutlich verbessert.

Beispiel 5

Eine Lösung aus

8,4 Gt eines Mischkondesats aus 3-Methoxy-diphenylamin-4-diazoniumsulfat, 4-Methoxymethyl-4'-methyl-diphenylether und 1,4-Bis-methoxymethyl-benzol im Molverhältnis 1:1:1, ausgefällt als Mesitylensulfonat,

30 Gt Polyvinylformal (MG 30.000; 7% Vinylalkohol-; 20—27% Vinylacetate- und um 50% Vinylformaleinheiten),
28 Gt des in Beispiel 3 angegebenen Monomeren,
2,2 Gt 2-(4-Ethoxy-naphth-1-yl-4,6-bis-trichlormethyl-s-triazin,
0,7 Gt Phosphorsäure,
2,2 Gt eines Kupferphthalocyanin-Bluapigments (C.I. 74 160),
20 Gt 2-Methoxy-ethylacetat,
610 Gt Methylethylketon und
350 Gt 2-Methoxy-ethanol

wurd mit einem Schichtgewicht von ca. 1,6 g/$m^2$ (trocken) auf elektrochemisch aufgerauhte, anodisierte Aluminiumfolie aufgebracht.

Die getrocknete Druckplatte wurde unter einer Testvorlage belichtet und mit folgender Lösung entwickelt:

60 Gt Propylenglykolmonomethylether,
10 Gt Glycerin,
5 Gt 2-Hydroxy-ethylacetat,
5 Gt Natriumbenzoat und
20 Gt Wasser.

Mit der fertigen Druckform wurden in einer Offset-Druckmaschine 200.000 Drucke hergestellt. Der Versuch wurde nach dieser Auflage abgebrochen, ohne daß die Druckform eine erkennbare Schädigung aufwies.

Ein gleich gutes Ergebnis wurde erzielt, wenn das Diazoniumsalzkondensat ersetzt wurde durch 5 Gt eines Kondensats aus 1 mol 3-Methoxy-diphenylamin-4-diazoniumsulfat und 1 mol 4,4'-Bis-methoxymethyl-diphenylether, ausgefällt als Benzolsulfonat.

In beiden Fällen war die Auflösung deutlich besser als bei einer vergleichbaren Druckplatte, die kein Diazoniumsalz-Polykondensationsprodukt enthielt.

## Beispiel 6

Eine Lösung aus

40 Gt eines Terpolymerisats aus 10 Gt Styrol, 60 Gt Hexylmethacrylat und 30 Gt Methacrylsäure (Mol-Gew. 35.000),
40 Gt eines (Diurethans aus 2,2,4-Trimethylhexamethylendiisocynat und Hydroxyethylmethacrylat Molverhältnis 1:2),
1,6 Gt 9-Phenylacridin,
650 Gt 2-Methoxy-ethanol,
180 Gt Methylethylketon und
0,24 Gt eines blauen Azofarbstoffs, erhalten durch Kuppeln von 2,4-Dinitro-6-chlor-benzoldiazoniumsalz mit 2-Methoxy-5-acetylamino-N-cyanoethyl-N-hydroxyethyl-anilin

wurde in zwei Teile geteilt und

a) ohne Zusatz

b) mit 6 Gt des Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat, versetzt,

auf elektrochemisch aufgerauhtes und anodisiertes Aluminium geschleudert.

Je 4 Proben der Muster a und b wurden im Vakuumrahmen unter einem Halbtonstufenkeil jeweils 15, 30, 45 und 60 Sekunden belichtet.

Anschließend wurden mit dem Entwickler von Beispiel 1 die nicht gehärteten Teile ausgewaschen. Die folgende Tabelle gibt an, wieviel Stufen jeweils ausreichend gehärtet waren.

| Belichtung / Probe | Sekunden | | | |
|---|---|---|---|---|
| | 15 | 30 | 45 | 60 |
| a | 2 Stufen | 3 Stufen | 4 Stufen | 4 Stufen |
| b | 4 Stufen | 6 Stufen | 8 Stufen | 9 Stufen |

d. h. die Probemuster b sind deutlich lichtempfindlicher als a.

Ähnlich gute Ergebnisse wurden erzielt, wenn ein Polykondensationsprodukt aus 1 mol 3-Methoxy-dienylamin-4-diazoniumsulfat und 1 mol 4,6-Bis-methoxymethyl-1,3-xylol eingesetzt wurde.

Beispiel 7

Zu einer Lösung aus

4,5 Gt des Polykondensationsproduktes aus 1 mol 3-methoxy-diphenylamin-4-diazoniumsulfat und 1 mol 4-Methyl-2,6-bis-(hydroxymethyl)-anisol, ausgefällt als Mesitylensulfonat,
125 Gt Tetrahydrofuran,
0,09 Gt Phosphorsäure,
0,3 Gt 2-(4-Methoxy-styryl)-4,6-bis-trichlormethyl-s-triazin und
0,2 Gt Viktoriareinblau FGA

wurden in drei verschiedenen Ansätzen a, b, c die Produkte

A: Umsetzungsprodukt aus einem Polyvinylbutyral (mit einem Molekulargewicht von 80.000, enthaltend 75% Vinylbutyral-, 1% Vinylacetat- und 20% Vinylalkoholeinheiten) mit Propenylsulfonylisocyanat mit der Säurezahl 140, und

B: Pentaerythrittetraacrylat

in folgenden Mengen zugesetzt:

| | Lösung a | Lösung b | Lösung c |
|---|---|---|---|
| A | 22,5 Gt | 15 Gt | 10 Gt |
| B | 7,5 Gt | 15 Gt | 20 Gt |

Mit diesen Lösungen a, b und c wurde anschließend elektrochemisch aufgerauhtes und anodisiertes Aluminium beschichtet (2,4—2,5 g/m$^2$). Die erhaltenen Druckplatten wurden unter einer Testvorlage 45 Sekunden belichtet.

Anschließend erfolge die Entwicklung (60 Sek.) mit einer Lösung aus

57 Gt Wasser,
35 Gt n-Propanol,
2 Gt Ethylenglykoldiacetat,
1,2 Gt Ammoniumsulfat,
1,1 Gt Diammoniumhydrogenphosphat und
3 Gt Polyvinylpyrrolidon.

Alle drei Druckformen zeichneten sich durch eine vorzügliche Auflösung der Bildelemente aus sowie durch gute Farb- und Waserführung beim Druckversuch in einer Offset-Maschine.

Änlich gut Ergebnisse wurden erzielt, wenn das Diazoniumpolykondensat durch ein Kondensationsprodukt aus 1 mol Diphenylamin-4-diazoniumsulfat und 1 mol 4,4'-Bis-methoxymethyl-diphenylether, abgeschieden als Mesitylensulfonat, ersetzt wurde.

Beispiel 8

Eine mit dünner Kupferfolie kaschierte isolierstoffplatte wurde nach der Reinigung der Kupferoberfläche mit Scheuermittel und Abspülen mit Aceton mit der nachstehenden Lösung beschichtet:

65 Gt des in Beispiel 6 angegebenen Monomeren,
65 Gt eines Terpolymerisats aus 10 Gt Styrol, 60 Gt n-Hexylmethacrylat und 30 Gt Methacrylsäure (Mol-Gew. 35.000),
2 Gt 9-Acryloylamino-acridin,
0,4 Gt des in Beispiel 6 angegebenen Azofarbstoffs,
12 Gt des Polykondensationsproduktes aus Beispiel 3b,
380 Gt Methylethylketon.

Dabei wurde ein Schichtgewicht von 10 g/m$^2$ eingestellt. Die Platte wurde unter einem Negativ, welches ein Schaltschema darstellt, belichtet und mit dem Entwickler aus Beispiel 1 entwickelt.

Durch Wegätzen des Kupfers an den freigelegten Stellen mit 40%iger wäßriger Eisen-(III)-chlorid-Lösung wurde eine kopierte Schaltung erhalten.

Ähnlich gute Ergebnisse konnten erzielt werden, wenn die gennante Lösung auf eine 25 µm dicke Polyethylenterephthalatfolie aufgebracht, getrocknet und die erhaltene Schicht unter Wärme und Druck auf die Kupferoberfläche übertragen wurde.

**Patentansprüche**

1. Lichtempfindliches Gemisch, das als wesentliche Bestandteile

a) ein Diazoniumsalz-Polykondensationsprodukt,

b) eine radiakalisch polymerisierbare Verbindung mit mindestens zwei endständigen ethylenisch ungesättigten Gruppen und einem Siedepunkt bei Normaldruck oberhalb 100°C,

c) einen unter Einwirkung von aktinischer Strahlung Radikale bildenen Polymerisationsinitiator und

d) ein in Wasser unlösliches, in organischen Lösungsmitteln lösliches polymeres Bindemittel enthält, dadurch gekennzeichnt, daß das Diazoniumsalz-Polykondensationsprodukt wiederkehrende Einheiten A—$N_2$X und B enthält, die durch zweibindige, von einer kondensationsfähigen Carbonylverbindung abgeleitete Zwischenglieder verbunden sind, wobei die Einheiten A—$N_2$X sich aus Verbindungen der allgemeinen Formel

$$(R^1—R^3—)_pR^2—N_2X$$

ableiten und wobei

X das Anion der Diazoniumverbindung,

p eine ganze Zahl von 1 bis 3,

$R^1$ einen carbocyclischen oder heterocyclischen aromatischen Rest mit mindestens einer kondesationsfähigen Position,

$R^2$ eine Arylengruppe der Benzol- oder Naphthalinreihe,

$R^3$ eine Einfachbindung oder eine der Gruppen:

$$—(Ch_2)_q—NR^4—$$

$$—O—(CH_2)_r—NR^4—,$$

$$—S—(CH_2)_r—NR^4—,$$

$$—S—CH_2—CO—NR^4—,$$

$$—O—R^5—O—,$$

$$—O—,$$

$$—S— \text{ oder}$$

$$—CO—NR^4—$$

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioesters, aromatischen Kohlenwasserstoffs, einer aromatischen heterocyclischen Verbindung oder eines organischen Säureamids bedueten.

2. Lichtempfindliches Gemisch nach Anspruch 1, dadurch gekennzeichnet, daß das Diazoniumsalz-Polykondensationsprodukt im Mittel 0,1 bis 50 Einheiten B je Einheit A—$N_2$X enthält.

3. Lichtempfindliches Gemisch nach Anspruch 1, dadurch gekennzeichnet, daß die Verbindung $(R^1—R^3—)_pR^2—N_2X$ ein unsubstituiertes oder durch Alkyl-, Alkoxygruppen oder Halogenatome substituiertes Diphenylamin-4-diazoniumsalz ist.

4. Lichtempfindliches Gemisch nach Anspruch 1, dadurch gekennzeichnet, daß die Einheiten B von einem gegebenenfalls substituierten Diphenylether, Diphenylsulfid, Diphenylmethan oder Diphenyl abgeleitet sind.

5. Lichtempfindliches Gemisch nach Anspruch 1, dadurch gekennzeichnet, daß die radikalisch polymerisierbare Verbindung ein Acryl- oder Methacrylsäureester eines mehrwertigen Alkohols ist.

6. Lichtempfindliches Gemisch nach Anspruch 1, dadurch gekennzeichnet, daß der Polymerisationsinitiator eine Verbindung mit mindestens einer photolytisch spaltbaren Trichlormethylgruppe ist.

7. Lichtempfindliches Gemisch nach Anspruch 1, dadurch gekennzeichnet, daß es 5 bis 60 Gew.-% Diazoniumsalz-Polykondensationsprodukt, 10 bis 65 Gew.-% radikalisch polymerisierbare Verbindung, 0,05 bis 10 Gew.-% Initiator und 5 bis 80 Gew.-% Bindemittel enthält.

8. Lichtempfindliches Aufzeichnungsmaterial mit einem Schichtträger und einer darauf aufgebrachten lichtempfindliche Schicht, dadurch gekennzeichnet, daß die lichtempfindliche Schicht aus einem Gemisch gemäß Anspruch 1 besteht.

**Revendications**

1. Composition photosensible qui contient en tant que composants essentiels

a) un produit de polycondensation de sel de diazonium,

b) un composé polymérisable par polymérisation radicalaire, comportant au moins deux groupes

terminaux à insaturation éthylénique et ayant un point d'ébullition de plus de 100°C sous la pression normale,

c) un initiateur de polymérisation formant des radicaux sous l'action d'un rayonnement actinique, et

d) un liant polymère insoluble dans l'eau, soluble dans des solvants organiques,

caractérisée en ce que le produit de polycondensation de sel de diazonium contient des motifs répétitifs $A—N_2X$ et B qui sont liés par de chaînons intermédiaires bivalents, dérivés d'un composé carbonyle condensable, les motifs $A—N_2X$ étant dérivés de composés de formule générale

$$(R^1—R^3—)_pR^2—N_2X$$

dans laquelle

X représente l'anion du composé diazonium,

p est un nombre entier allant de 1 à 3,

$R^1$ représente un radical aromatique carbocyclique ou hétérocyclique comportant au moins une position condensable,

$R^2$ représente un groupe arylène de la série du benzène ou du naphtalène,

$R^3$ représente une simple liaison ou l'un des groupes

$$—(CH_2)_q—NR^4—,$$

$$—O—(CH_2)_r—NR^4—,$$

$$—S—(CH_2)_r—NR^4—,$$

$$—S—CH_2—CO—NR^4—,$$

$$—O—R^5—O—,$$

$$—O—,$$

$$—S— \text{ ou}$$

$$—CO—NR^4—,$$

dans lesquels

q est un nombre allant de 0 à 5,

r est un nombre allant de 2 à 5,

$R^4$ est un atome d'hydrogène ou un groupe alkyle ayant de 1 à 5 atomes de carbone, un groupe aralkyle ayant de 7 à 12 atomes de carbone ou un groupe aryle ayant de 6 à 12 atomes de carbone, et

$R^5$ est un groupe arylène ayant de 6 à 12 atomes de carbone, et

B représente le radical exempt de groupes diazonium d'une amine aromatique, d'un phénol, d'un thiophénol, d'un phénol-éther, d'un thioéther aromatique, d'un hydrocarbure aromatique, d'un composé aromatique hétérocyclique ou d'un amide organique.

2. Composition photosensible selon la revendication 1, caractérisée en ce que le produit de polycondensation de sel de diazonium contient en moyenne de 0,1 à 50 motifs B par motif $A—N_2X$.

3. Composition photosensible selon la revendication 1, caractérisée en ce que le composé $(R^1—R^3—)_pR^2—N_2X$ est un sel de diphénylamine-4-diazonium non substitué ou substitué par des groupes alkyle ou alcoxy par des atomes d'halogène.

4. Composition photosensible selon la revendication 1, caractérisée en ce que les motifs B sont dérivés d'un éther diphénylique, sulfure de diphényle, diphénylméthane ou diphényle, éventuellement substitué.

5. Composition photosensible selon la revendication 1, caractérisée en ce que le composé polymérisable par polymérisation radicalaire est un ester acrylique ou méthacrylique d'un polyalcool.

6. Composition photosensible selon la revendication 1, caractérisée en ce que l'initiateur de polymérisation est un composé comportant au moins un groupe trichlorométhyle séparable par photolyse.

7. Composition photosensible selon la revendication 1, caractérisée en ce qu'elle contient de 5 à 60% en poids de produit de polycondensation de sel de diazonium, de 10 à 65% en poids de composé polymérisable par polymérisation radicalaire, de 0,05 à 10% en poids d'initiateur et de 5 à 80% en poids de liant.

8. Matériau reprographique photosensible, comportant un support de couche et un couche photosensible appliquée sur celui-ci, caractérisé en ce que la couche photosensible est constituée d'une composition selon la revendication 1.

**Claims**

1. A photosensitive mixture containing, as the essential constituents

a) a diazonium salt polycondensation product;

b) a compound which is polymerizable by a free-radical process, comprising at least two terminal ethylenically unsaturated groups and having a boiling point, at normal pressure, of above 100°C;

c) a polymerization initiator which under the action of actinic radiation forms free radicals; and

d) a polymeric binder which is insoluble in water, but soluble in organic solvents,

characterized in that the diazonium salt polycondensation product comprises recurring units of the formulas $A—N_2X$ and B which are linked by bivalent intermediate members derived from a carbonyl compound that is capable of condensation, whereby the $A—N_2X$ units are derived from compounds of the general formula

$$(R^1—R^2—)_pR^2—N_2X$$

in which

X denotes the anion of the diazonium compound,

p denotes an integer from 1 to 3,

$R^1$ denotes a carbocyclic or heterocyclic aromatic group, with at least one position being capable of condensation,

$R^2$ denotes an arylene group of the benzene or naphthalene series,

$R^3$ denotes a single bond or one of the groups:

$$—(CH_2)_q—NR^4—,$$

$$—O—(CH_2)_r—NR^4—,$$

$$—S—(CH_2)CO—NR^4—,$$

$$—S—CH_2—CO—NR^4—,$$

$$—O—R^5—O—,$$

$$—O—,$$

$$—S— \text{ or}$$

$$—CO—NR^4—$$

q denotes an integer from 0 to 5,

r denotes an integer from 2 to 5,

$R^4$ denoting hydrogen, an alkyl group having 1 to 5 carbon atoms, an aralkyl group having 7 to 12 carbon atoms or an aryl group having 6 to 12 atoms, and

$R^5$ denoting an arylene group having 6 to 12 carbon atoms, and

B denotes the diazonium-group-free radical of an aromatic amine, a phenol, a thiophenol, a phenol ether, an aromatic thioether, an aromatic hydrocarbon, an aromatic heterocyclic compound or an organic acid amide.

2. A photosensitive mixture as claimed in claim 1, characterized in that an average number of 0.1 to 50 units of B is contained in the diazonium salt polycondensation product per 1 unit of $A—N_2X$.

3. A photosensitive mixture as claimed in claim 1, characterized in that the compound $(R^1—R^3)_pR^2—N_2X$ is a diphenyl-amine-4-diazonium salt which is unsubstituted or substituted by alkyl groups, alkoxy groups or halogen atoms.

4. A photosensitive mixture as claimed in claim 1, characterized in that the units B are derived from an optionally substituted diphenyl ether, diphenyl sulfide, diphenyl methane or diphenyl.

5. A photosensitive mixture as claimed in claim 1, characterized in that the compound which is polymerizable by a free-radical process is an acrylic or methacrylic acid ester of polyhydric alcohol.

6. A photosensitive mixture as claimed in claim 1, characterized in that the polymerization initiator is a compound possessing at least one trichloromethyl group which can be split off by a photolytic process.

7. A photosensitive mixture as claimed in claim 1, characterized in that 5 to 60% by weight of diazonium salt polycondensation product, 10 to 65% by weight of compound which can be polymerized by a free-radical process, 0.05 to 10% by weight of initiator and 5 to 80% by weight of binder are contained therein.

8. A photosensitive recording material comprising a layer support and a photosensitive layer applied thereto, characterized in that the photosensitive layer is constituted by a mixture as claimed in claim 1.